# FASCICULE DE BREVET EUROPEEN

(11) **EP 3 529 651 B1**
(45) Date de publication et mention de la délivrance du brevet: **01.12.2021**
(21) Numéro de dépôt: 17791331.6
(22) Date de dépôt: 19.10.2017
(51) Int. Cl.: G02B 6/42, G02B 6/44, G02B 6/38, H05K 1/02, H05K 3/34

(54) **BOBINE DESTINÉE À ENROULER UN TRONCON DE CÂBLE DE FIBRE OPTIQUE**
SPULE ZUM AUFWICKELN EINER KABELLÄNGE EINES OPTISCHEN GLASFASERKABELS
REEL FOR WINDING A LENGTH OF OPTICAL FIBER CABLE

(30) Priorité: 21.10.2016 FR 1660259
(43) Date de publication de la demande: 28.08.2019
(73) Titulaire: Sagemcom Broadband SAS, 92500 Rueil-Malmaison (FR)
(72) Inventeur: KOHN, Stéphane, 92500 Rueil Malmaison (FR)
(74) Mandataire: Lavaud, Thomas
(86) Numéro de dépôt international: PCT/EP2017/076782
(87) Numéro de publication internationale: WO 2018/073380

(56) Documents cités:
- FR-A1- 2 814 246
- US-A1- 2004 124 233
- US-A1- 2009 010 600
- US-A1- 2010 282 891
- US-A1- 2016 124 164

## Description

L'invention concerne le domaine des bobines destinées à enrouler un tronçon de câble de type câble de fibre optique (parfois appelées bobines de lovage).

### ARRIERE PLAN DE L'INVENTION

On assiste actuellement à un déploiement massif de réseaux de fibres optiques par les opérateurs internet, grâce auxquels les abonnés bénéficient d'un débit de données très important.

Les fabricants de passerelles résidentielles doivent intégrer dans les passerelles résidentielles qu'ils fournissent des interfaces de communication par fibre optique qui permettent de relier les passerelles résidentielles aux réseaux de fibres optiques.

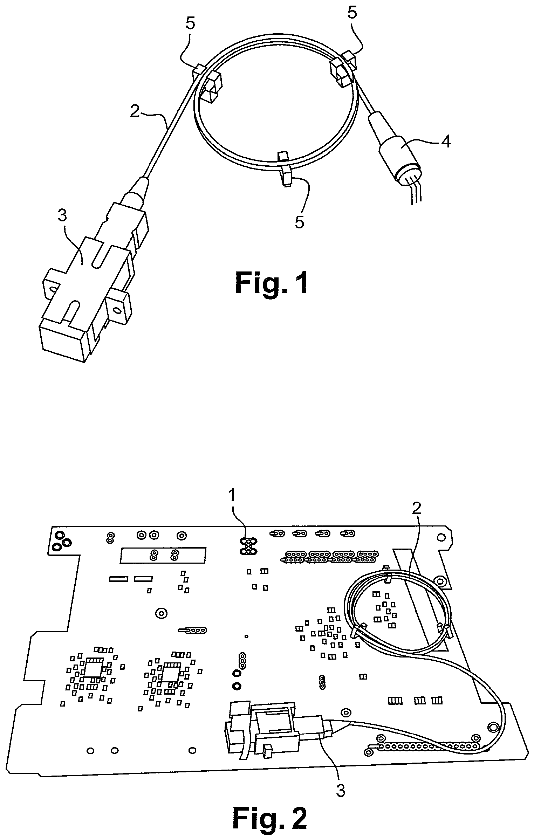

Classiquement, en référence aux figures 1 et 2, un procédé d'assemblage d'une passerelle résidentielle consiste à spécifier, à faire fabriquer puis à se faire livrer une carte électrique 1 accompagnée d'un câble de fibre optique 2, ledit câble de fibre optique 2 comprenant à une première extrémité un connecteur de traversée de cloison 3 et à une deuxième extrémité un connecteur circulaire 4.

Le câble 2 est généralement maintenu enroulé sur une face de la carte électrique 1 grâce à trois picots 5 encliquetés sur la face de la carte électrique 1.

Suite à la livraison de la carte électrique 1 et du câble 2, des composants électriques sont positionnés sur la carte électrique 1. Les composants électriques sont alors soudés, généralement en utilisant un procédé de soudage à la vague. Le connecteur circulaire 4 du câble 2 est connecté à l'un de ces composants électriques (par exemple, à un triplexeur).

Puis, l'interface de communication par fibre optique de la carte électrique 1 est testée grâce au connecteur de traversé de cloison 3. La carte électrique 1, munie du câble 2, est ensuite intégrée dans un boîtier, éventuellement avec d'autres cartes électriques, pour former la passerelle résidentielle.

Le procédé d'assemblage qui vient d'être décrit présente plusieurs inconvénients.

Lorsque l'on tire sur le câble 2 pour le fixer sur la carte électrique 1, on réduit le diamètre de l'enroulement formé par le câble enroulé, qui présente alors une forme triangulaire qui risque d'endommager le câble 2 et qui tend à diminuer les performances de la communication par fibre optique. De plus, lors du soudage des composants électriques, le câble 2 ne peut demeurer sur la carte électriques 1 et subit des manipulations tendant à dégrader celui-ci. Le document US 2009 010600 A1 décrit un dispositif de connexion comprenant une bobine permettant d'enrouler un tronçon de fibre optique. Le dispositif de connexion comporte de plus des moyens de fixation agencés pour positionner la bobine à plat sur une face d'une carte électrique.

### OBJET DE L'INVENTION

L'invention a pour objet d'assembler un équipement électrique équipé d'une interface de communication par fibre optique (telle que la passerelle résidentielle qui vient d'être décrite), sans rencontrer les inconvénients qui viennent d'être évoqués.

### RESUME DE L'INVENTION

En vue de la réalisation de ce but, on propose une bobine destinée à enrouler un tronçon de câble de type câble de fibre optique, comportant :
- un support d'enroulement du tronçon de câble ;
- des moyens de maintien adaptés à maintenir le tronçon de câble enroulé autour du support d'enroulement ;
- des premiers moyens de fixation agencés pour fixer la bobine à un bord d'une carte électrique de sorte que la bobine soit positionnée latéralement par rapport à la carte électrique ;
- des deuxièmes moyens de fixation agencés pour fixer la bobine à plat sur une face de la carte électrique.

En enroulant le tronçon de câble autour du support d'enroulement et en fixant la bobine sur la carte électrique grâce aux premiers moyens de fixation ou aux deuxièmes moyens de fixation, on positionne le tronçon de câble sur la carte électrique tout en assurant que le diamètre de l'enroulement formé par le câble enroulé n'est pas réduit lorsque l'on tire sur celui-ci. En fixant la bobine sur la carte électrique grâce aux deuxièmes moyens de fixation, on positionne la bobine latéralement par rapport à la carte électrique, ce qui permet de réaliser l'opération de soudage à la vague tout en maintenant la bobine fixée sur la carte électrique.

On propose aussi un système comprenant une carte électrique et une bobine telle que celle qui vient d'être décrite.

On propose de plus un procédé d'assemblage d'un équipement électrique comprenant les étapes :
- de fixer une bobine telle que celle qui vient d'être décrite latéralement par rapport à la carte électrique grâce aux premiers moyens de fixation de la bobine, un câble de type câble de fibre optique étant entouré autour de la bobine ;
- d'envelopper la bobine d'un dispositif de protection thermique ;
- de souder des composants électriques sur la carte électrique ;
- de fixer la bobine sur la face de la carte électrique grâce aux deuxièmes moyens de fixation de la bobine ;
- d'intégrer la carte électrique à l'intérieur d'un boîtier de l'équipement électrique.

L'invention sera mieux comprise à la lumière de la description qui suit d'un mode de mise en œuvre particulier non limitatif de l'invention.

### BREVE DESCRIPTION DES DESSINS

Il sera fait référence aux dessins annexés, parmi lesquels :
- la figure 1 est une vue en perspective d'un câble de fibre optique et de picots permettant de fixer le câble à une carte électrique selon l'art antérieur ;
- la figure 2 représente la carte électrique et le câble de fibre optique fixé à la carte électrique selon l'art antérieur ;
- la figure 3 est une vue de dessus en perspective de la bobine selon l'invention ;
- la figure 4 est une vue de dessous en perspective de la bobine selon l'invention ;
- la figure 5 représente la bobine selon l'invention et le câble de fibre optique comprenant à une première extrémité un connecteur de traversée de cloison et à une deuxième extrémité un connecteur circulaire relié à un composant de type triplexeur ;
- la figure 6 représente une face supérieure d'une carte électrique sur laquelle est fixée une bobine selon l'invention grâce à des premiers moyen de fixation de la bobine ;
- les figures 7 et 8 sont des vues analogues à la figure 6, un connecteur de traversée de cloison étant monté sur des premiers moyens d'accueil de la bobine ;
- la figure 9 représente une face supérieure de la carte électrique ;
- la figure 10 représente une face inférieure de la carte électrique ;
- la figure 11 représente une face inférieure de la carte électrique, la bobine selon l'invention étant fixée grâce à des deuxièmes moyens de fixation de la bobine ;
- les figures 12 et 13 sont des vues analogues à la figure 11, le connecteur de traversée de cloison étant monté sur des deuxièmes moyens d'accueil de la carte électrique.

### DESCRIPTION DETAILLEE DE L'INVENTION

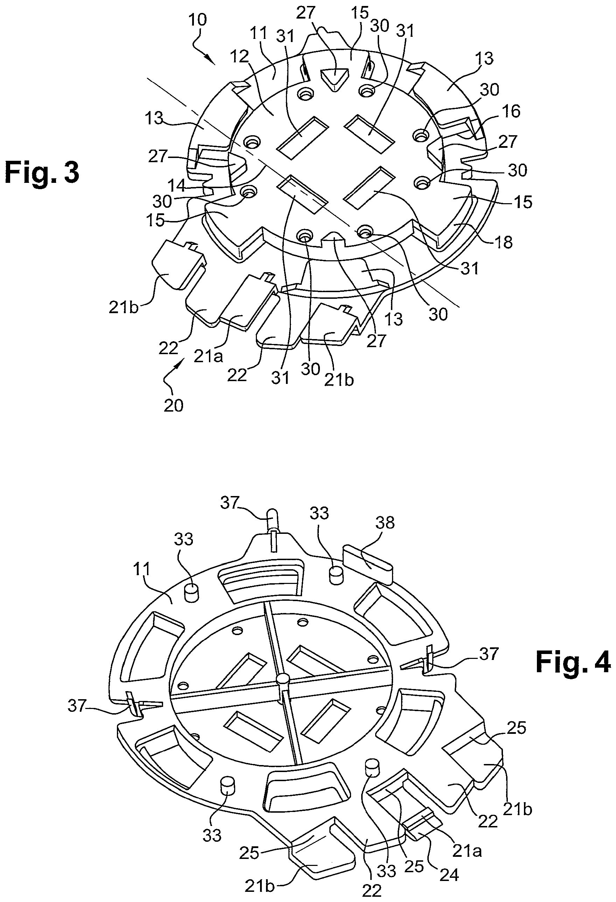

En référence aux figures 3 et 4, la bobine selon l'invention 10 est destinée à enrouler un tronçon de câble de type câble de fibre optique, et à être montée sur une carte électrique. La carte électrique est elle-même destinée à être intégrée dans un boîtier d'un équipement électrique, ici dans un boîtier d'une passerelle résidentielle.

La bobine 10, de forme générale plate, comporte un flanc 11 de forme générale circulaire, et présente une face supérieure et une face inférieure.

La face supérieure de la bobine 10, visible sur la figure 3, comporte un support d'enroulement 12 du tronçon de câble. Le support d'enroulement 12 présente ici une forme générale cylindrique. Le support d'enroulement 12 est positionné au centre du flanc 11 et de la bobine 10.

La face supérieure de la bobine 10 comprend des moyens de maintien adaptés à maintenir le tronçon de câble enroulé autour du support d'enroulement 12.

Les moyens de maintien comprennent trois premières languettes 13 qui s'étendent depuis une périphérie de la bobine 10 vers une face supérieure 14 du support d'enroulement 12 et trois deuxièmes languettes 15 qui s'étendent depuis la face supérieure 14 du support d'enroulement 12 vers la périphérie de la bobine 10.

Les premières languettes 13, les deuxièmes languettes 15, la périphérie de la bobine 10 et une périphérie du support d'enroulement 12 définissent ainsi un canal 16 dans lequel s'étend le tronçon de câble.

On note que la position de chaque première languette 13 est diamétralement opposée, par rapport au support d'enroulement 12, à la position d'une deuxième languette 15.

On note aussi que chaque deuxième languette 15 comporte à son extrémité libre une excroissance 18 formant crochet.

Chaque première languette 13 définit ainsi une entrée axiale pour le tronçon de câble, alors que chaque deuxième languette 15 définit une entrée radiale pour le tronçon de câble. Les positions diamétralement opposées des premières languettes 13 et des deuxièmes languettes 15 permettent d'empêcher que le tronçon de câble ne soit déroulé accidentellement.

La bobine 10 comporte de plus des premiers moyens de fixation destinés à fixer la bobine 10 à un bord de la carte électrique de sorte que la bobine 10 soit positionnée latéralement par rapport à la carte électrique. Les premiers moyens de fixation comportent des moyens d'encliquetage 20 destinés à coopérer avec des moyens d'encliquetage complémentaires de la carte électrique disposés à proximité d'un bord de la carte électrique.

Les moyens d'encliquetage 20 de la bobine 10 comportent cinq languettes qui s'étendent depuis la périphérie du flanc 11 vers l'extérieur de la bobine 10, parallèlement au flanc 11. Les cinq languettes comprennent trois languettes supérieures 21 et trois languettes inférieures 22. Lorsque la bobine 10 est fixée au bord de la carte électrique grâce aux premiers moyens de fixation, la carte électrique s'étend entre les trois languettes supérieures 21 et les deux languettes inférieures 22.

Parmi les trois languettes supérieures 21, on trouve une languette supérieure centrale 21a comportant à son extrémité libre une surépaisseur 24 (visible sur la figure 4) formant crochet, et deux languettes supérieures extérieures 21b qui comprennent chacune à leur extrémité libre un chanfrein. La languette supérieure centrale 21a est déformable, alors que les deux languettes supérieures extérieures 21b sont rigides.

Les deux languettes inférieures 22, quant à elles, sont déformables, et comprennent chacune à leur extrémité libre un chanfrein. Les deux languettes inférieures 22 sont des languettes de guidage.

Ainsi, lorsque la bobine 10 est positionnée latéralement par rapport à la carte électrique pour être fixée au bord de la carte électrique, la languette supérieure centrale 21a et les deux languettes inférieures 22 s'écartent légèrement pour guider la bobine 10, puis le crochet 24 de la languette supérieure centrale 21a vient se positionner dans une fente des moyens d'encliquetage complémentaires de la carte électrique.

On note que les languettes supérieures 21 comportent chacune une face 25 (visible sur la figure 4) perpendiculaire au flanc 11 qui forme une butée contre une épaisseur de la carte électrique.

La face supérieure de la bobine 10 comporte par ailleurs quatre premiers pions 27 de section triangulaire disposés sur la face supérieure 14 du support d'enroulement 12. Les quatre premiers pions 27 sont positionnés sur la périphérie du support d'enroulement 12 en étant régulièrement espacés.

Les quatre premiers pions 27 forment des butées supérieures destinées à assurer une distance minimale entre la face supérieure de la bobine 10 et le boîtier à l'intérieur duquel est intégrée la carte électrique.

La face supérieure de la bobine 10 comporte en outre des premiers moyens d'accueil susceptibles d'accueillir un connecteur de type connecteur de traversée de cloison. Les premiers moyens d'accueil sont positionnés sur la face supérieure 14 du support d'enroulement 12. Les premiers moyens d'accueil comportent quatre ensembles comprenant chacun deux trous circulaires 30 situés à la périphérie de la face supérieure 14 du support d'enroulement 12 et une cavité rectangulaire 31 située dans une zone centrale de la face supérieure 14 du support d'enroulement 12. Les quatre ensembles définissent ainsi quatre positions d'accueil régulièrement espacées sur la face supérieure 14 du support d'enroulement 12.

La face inférieure de la bobine, visible sur la figure 4, comporte quant à elle quatre deuxièmes pions 33 de section circulaire positionnés sur la périphérie de la face inférieure de la bobine 10.

Les quatre deuxièmes pions 33 forment des butées inférieures destinées à assurer une hauteur minimale entre la face inférieure de la bobine 10 et une face de la carte électrique lorsque la bobine 10 est fixée sur la face de la carte électrique. Cette hauteur minimale permet notamment de positionner des composants électriques sur la carte électrique et sous la bobine.

La face inférieure de la bobine 10 comporte en outre des deuxièmes moyens de fixation destinés à fixer la bobine 10 à plat sur une face de la carte électrique. Les deuxièmes moyens de fixation comportent trois pions d'encliquetage 37 et une nervure de positionnement 38, qui sont positionnés sur une périphérie de la face inférieure de la bobine 10.

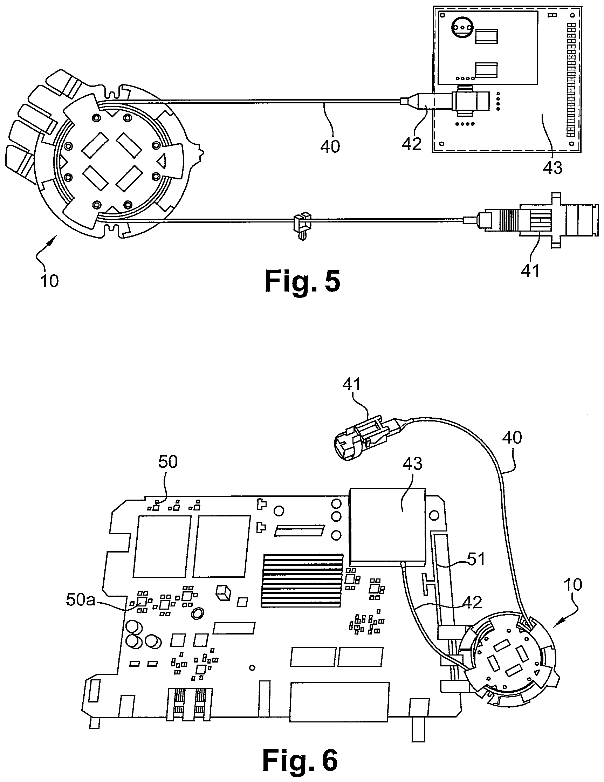

En référence à la figure 5, le tronçon de câble 40 dont il est ici question comprend à une première extrémité un connecteur de traversée de cloison 41 et à une deuxième extrémité un connecteur circulaire 42 destiné à être relié à un composant de type triplexeur 43 sur la carte électrique.

On décrit maintenant un procédé d'assemblage selon l'invention d'une passerelle résidentielle, ledit procédé d'assemblage utilisant la bobine 10.

En référence à la figure 6, la carte électrique 50 est fabriquée puis livrée, accompagnée de la bobine 10 sur laquelle est enroulé le tronçon de câble 40. La bobine 10 est fixée sur la carte électrique 50 à un bord de la carte électrique 50 grâce aux premiers moyens de fixation de la bobine 10, c'est-à-dire grâce aux moyens d'encliquetage de la bobine 10 et aux moyens d'encliquetage complémentaires de la carte électrique 50. Le connecteur de traversée de cloison 41 n'est initialement pas monté sur la carte électrique ou sur la bobine.

Puis, des composants électriques, et notamment un triplexeur 43, sont positionnés sur une face supérieure 50a de la carte électrique 50. Le connecteur circulaire 42 du tronçon de câble est connecté au triplexeur 43.

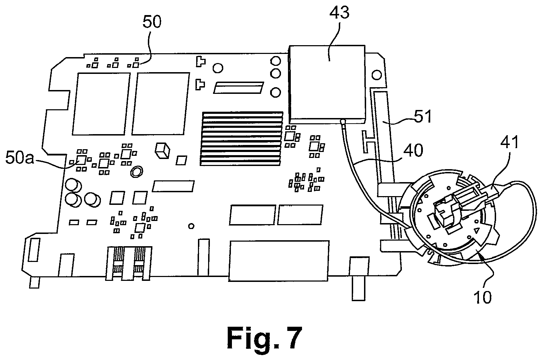

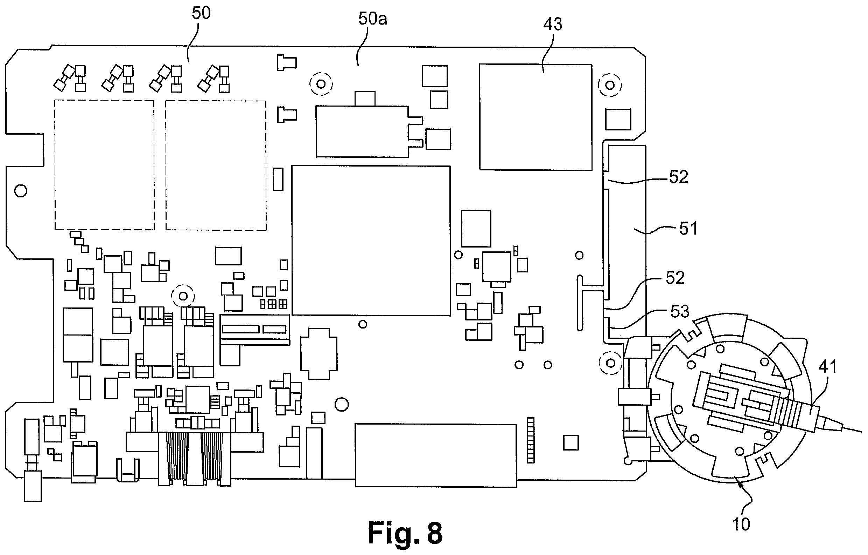

En référence aux la figures 7 et 8, le connecteur de traversée de cloison 41 est alors positionné sur les premiers moyens d'accueil de la bobine 10. La bobine 10, le tronçon de câble 40 et le connecteur de traversée de cloison 41 sont enveloppés par un dispositif de protection thermique, en l'occurrence par une chaussette de protection (non visible sur les figures) fabriquée en un matériau ignifugé et hermétique à la chaleur.

Les composants électriques sont alors soudés sur la face supérieure 50a de la carte électrique 50 via un soudage à la vague.

La chaussette de protection est alors retirée, et la bobine 10 est détachée du bord de la carte électrique 50. Le connecteur circulaire 42 du tronçon de câble 40 reste connecté au triplexeur 43.

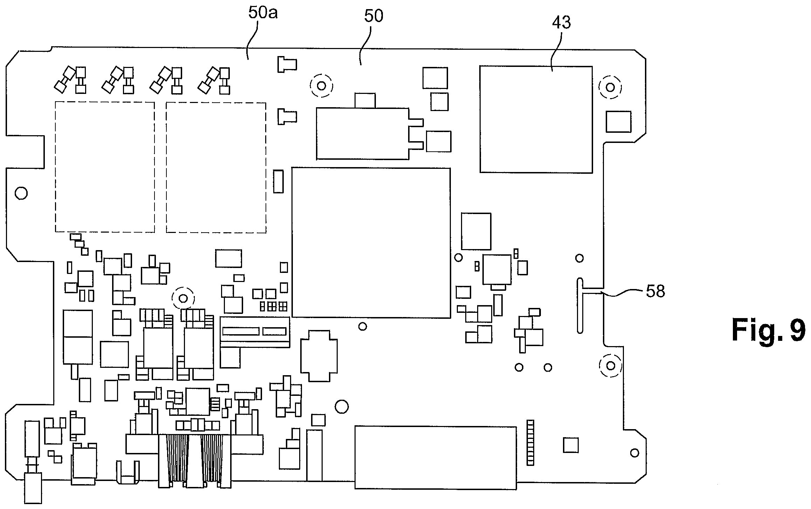

On note, comme cela est bien visible sur les figures 8 et 9, que le bord de la carte électrique 50 auquel est fixée la bobine 10 constitue une portion de circuit imprimée détachable 51. La portion de circuit imprimée détachable 51 est reliée au reste du circuit imprimé de la carte électrique 50 par de fines portions de circuit imprimé 52 qui permettent de détacher la portion de circuit imprimée détachable 51. La figure 9 montre la carte électrique 50 alors que la portion de circuit imprimée détachable 51 a été détachée.

On note aussi que, lorsque la portion de circuit imprimée détachable 51 est présente sur la carte électrique 50, l'espace 53 entre la portion de circuit imprimée détachable 51 et le reste du circuit imprimé de la carte électrique 50 définit la fente des moyens d'encliquetage complémentaires de la carte électrique 50. La surépaisseur 24 (visible sur la figure 4) formant crochet de la languette supérieure centrale 21a de la bobine 10 est insérée dans ladite fente lorsque la bobine 10 est montée sur la carte électrique 50 via les premiers moyens de fixation.

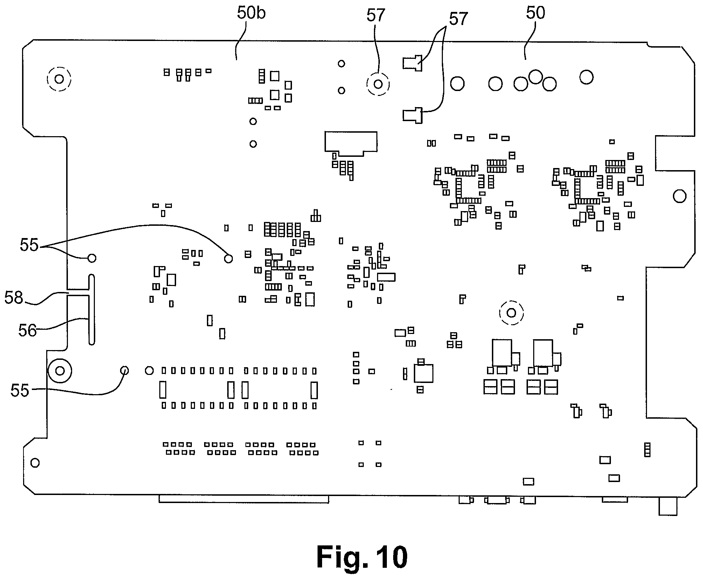

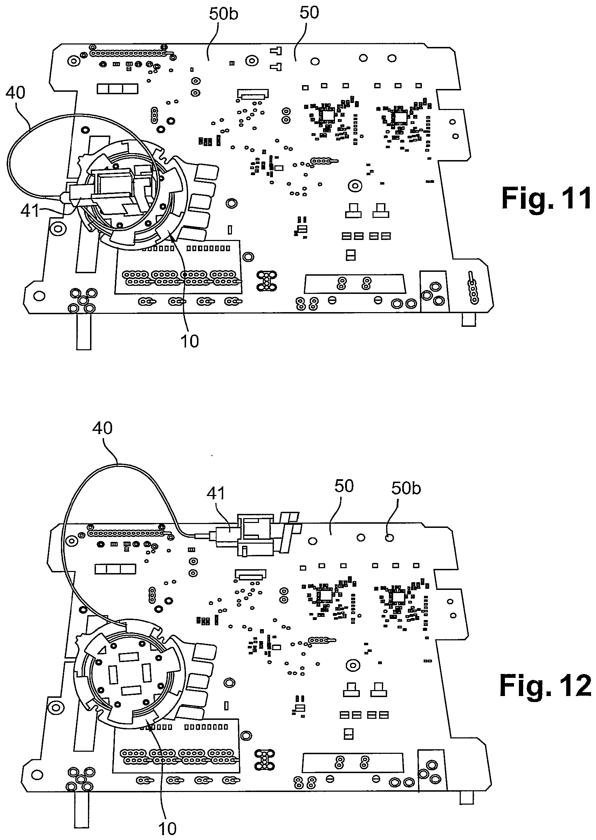

En référence aux figures 10 et 11, la carte électrique 50 est alors retournée, et la bobine 10 est fixée à plat sur la face inférieure 50b de la carte électrique 50 grâce aux deuxièmes moyens de fixation de la bobine 10. En l'occurrence, les trois pions d'encliquetage 37 des deuxièmes moyens de fixation sont insérés dans trois orifices d'encliquetage 55 de la carte électrique, et la nervure de positionnement est insérée dans une fente de positionnement 56 de la carte électrique 50. Le connecteur de traversée de cloison 41 est toujours monté sur la bobine 10.

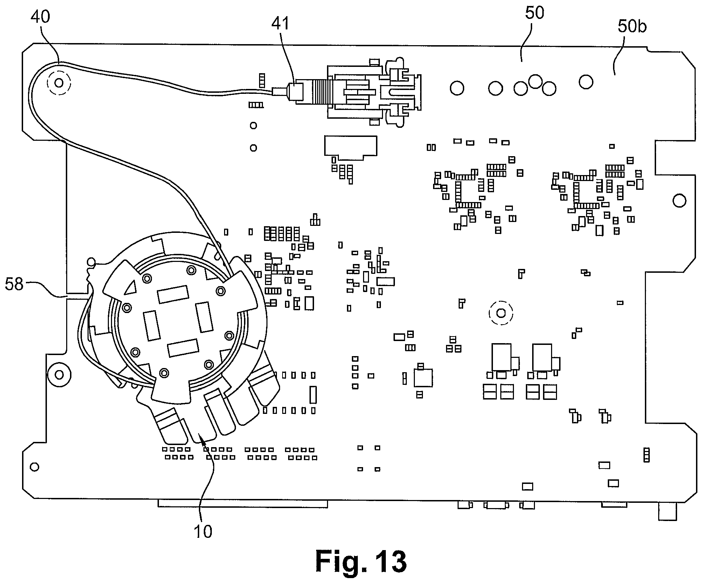

Puis, en référence aux figures 12 et 13, le connecteur de traversée de cloison 41 est positionné sur des deuxièmes moyens d'accueil 57 de la carte électrique 50.

Le tronçon de câble 40 est ainsi relié via le connecteur circulaire 42 au triplexeur 43 monté sur la face supérieure 50a de la carte électrique 50, alors que le connecteur de traversée de cloison 41 est positionné sur la face inférieure 50b de la carte électrique. Le tronçon de câble 40 chemine entre la face supérieure 50a de la carte électrique 50 et la face inférieure 50b de la carte électrique 50 via une fente de passage 58 qui s'étend dans la continuité de la fente de positionnement 56 perpendiculairement à celle-ci.

Un passe-câble (non représenté sur les figures) est fixée sur la face inférieure de la carte électrique 50.

La carte électrique 50 et le tronçon de câble 40 sont alors prêts pour être testés, via notamment le connecteur de traversée de cloison 41, puis à être intégrés dans un boîtier de la passerelle résidentielle.

Bien entendu, l'invention n'est pas limitée au mode de réalisation décrit mais englobe toute variante entrant dans le champ de l'invention telle que définie par les revendications.

On a ici indiqué que la carte électrique est intégrée dans une passerelle résidentielle, mais l'invention s'applique à tout type d'équipement électrique et bien sûr, à tout type de câble.

Le nombre de premières languettes, de deuxièmes languettes, de languettes supérieures, de languettes inférieures, de trous circulaires, de cavités rectangulaires, de premiers pions, de deuxièmes pions, de pions d'encliquetage, de nervures de positionnement, d'orifices d'encliquetage, etc..., peut bien sûr être différent de celui du mode de réalisation décrit.

## Revendications

1. Bobine destinée à enrouler un tronçon de câble (40) de type câble de fibre optique, comportant :
- un support d'enroulement (12) du tronçon de câble ;
- des moyens de maintien adaptés à maintenir le tronçon de câble enroulé autour du support d'enroulement ;
- des premiers moyens de fixation agencés pour fixer la bobine à un bord d'une carte électrique (50) de sorte que la bobine soit positionnée latéralement par rapport à la carte électrique ;
- des deuxièmes moyens de fixation agencés pour fixer la bobine à plat sur une face de la carte électrique.

2. Bobine selon la revendication 1, dans laquelle les premiers moyens de fixation comportent des moyens d'encliquetage (20) agencés pour coopérer avec des moyens d'encliquetage complémentaires de la carte électrique disposés à proximité d'un bord de la carte électrique.

3. Bobine selon la revendication 1, dans laquelle les moyens de maintien comportent au moins une première languette (13) qui s'étend depuis une périphérie de la bobine (10) vers le support d'enroulement (12) et une deuxième languette (15) qui s'étend depuis le support d'enroulement vers la périphérie de la bobine, la première languette, la deuxième languette, la périphérie de la bobine (10) et une périphérie du support d'enroulement (12) définissant un canal (16) dans lequel s'étend le tronçon de câble.

4. Bobine selon la revendication 3, dans laquelle la première languette (13) définit ainsi une entrée axiale pour le tronçon de câble, alors que la deuxième languette (15) définit une entrée radiale pour le tronçon de câble.

5. Bobine selon la revendication 1, dans laquelle une face supérieure de la bobine (10) comprend une butée supérieure (27) agencée pour assurer une distance minimale entre la face supérieure de la bobine (10) et un boîtier à l'intérieur duquel est intégrée la carte électrique.

6. Bobine selon la revendication 1, dans laquelle une face inférieure de la bobine comprend une butée inférieure (33) agencée pour assurer une hauteur minimale entre la face inférieure de la bobine et la face de la carte électrique lorsque la bobine est fixée sur la face de la carte électrique.

7. Bobine selon la revendication 1, comportant des premiers moyens d'accueil (30, 31) susceptibles d'accueillir un connecteur de type connecteur de traversée de cloison.

8. Bobine selon la revendication 1, comportant une nervure de positionnement (38) agencée pour être insérée dans une fente de positionnement (56) correspondante pratiquée dans la carte électrique (50) pour positionner correctement la bobine.

9. Système comprenant une carte électrique (50) et une bobine (10) selon l'une des revendications précédentes.

10. Système selon la revendication 9, dans lequel les premiers moyens de fixation comportent des moyens d'encliquetage destinés à coopérer avec des moyens d'encliquetage complémentaires de la carte électrique disposés à proximité d'un bord de la carte électrique, les moyens d'encliquetage complémentaires de la carte électrique comprenant un espace compris entre une portion détachable de la carte électrique et le reste de la carte électrique.

11. Système selon la revendication 9, dans lequel la carte électrique comporte des deuxièmes moyens d'accueil (57) susceptible d'accueillir un connecteur de type connecteur de traversée de cloison.

12. Procédé d'assemblage d'un équipement électrique comprenant les étapes :
- de fixer une bobine (10) selon l'une des revendications 1 à 7 à un bord de la carte électrique (50) grâce aux premiers moyens de fixation de la bobine, un câble de type câble de fibre optique étant entouré autour de la bobine ;
- d'envelopper la bobine d'un dispositif de protection thermique ;
- de souder des composants électriques sur la carte électrique ;
- de fixer la bobine sur la face de la carte électrique grâce aux deuxièmes moyens de fixation de la bobine ;
- d'intégrer la carte électrique à l'intérieur d'un boîtier de l'équipement électrique.

13. Procédé d'assemblage selon la revendication 12, dans lequel le soudage des composants électriques est un soudage à la vague.

14. Procédé d'assemblage selon la revendication 12, comprenant en outre les étapes :
- préalablement au soudage des composants électriques, de connecter à une extrémité du câble un connecteur de type connecteur de traversée de cloison, et de positionner le connecteur de type connecteur de traversée de cloison sur des premiers moyens d'accueil de la bobine prévus à cet effet ;
- suite au soudage des composants, de positionner le connecteur sur des deuxièmes moyens d'accueil de la carte électrique prévus à cet effet.

## Patentansprüche

1. Rolle, die zum Aufrollen eines Kabelabschnitts (40) vom Typ Glasfaserkabel bestimmt ist, umfassend:
- einen Wicklungsträger (12) für den Kabelabschnitt;
- Haltemittel, die geeignet sind, den um den Wicklungsträger herum gewickelten Kabelabschnitt zu halten;
- erste Befestigungsmittel, die ausgebildet sind, um die Rolle an einem Rand einer elektrischen Karte (50) derart zu befestigen, dass die Rolle in Bezug auf die elektrische Karte seitlich positioniert ist;
- zweite Befestigungsmittel, die ausgebildet sind, um die Rolle flach auf einer Fläche der elektrischen Karte zu befestigen.

2. Rolle nach Anspruch 1, bei der die ersten Befestigungsmittel Rastmittel (20) umfassen, die ausgebildet sind, um mit komplementären Rastmitteln der elektrischen Karte zusammenzuwirken, die in der Nähe eines Randes der elektrischen Karte angeordnet sind.

3. Rolle nach Anspruch 1, bei der die Haltemittel mindestens eine erste Lasche (13) umfassen, die sich von einem Umfang der Rolle (10) in Richtung des Wicklungsträgers (12) erstreckt, sowie eine zweite Lasche (15), die sich von dem Wicklungsträger in Richtung des Umfangs der Rolle erstreckt, wobei die erste Lasche, die zweite Lasche, der Umfang der Rolle (10) und ein Umfang des Wicklungsträgers (12) einen Kanal (16) definieren, in dem sich der Kabelabschnitt erstreckt.

4. Rolle nach Anspruch 3, bei der die erste Lasche (13) somit einen axialen Eintritt für den Kabelabschnitt definiert, während die zweite Lasche (15) einen radialen Eintritt für den Kabelabschnitt definiert.

5. Rolle nach Anspruch 1, bei der eine Oberfläche der Rolle (10) einen oberen Anschlag (27) umfasst, der ausgebildet ist, um einen minimalen Abstand zwischen der Oberfläche der Rolle (10) und einem Gehäuse sicherzustellen, in dessen Innerem die elektrische Karte integriert ist.

6. Rolle nach Anspruch 1, bei der eine Innenfläche der Rolle einen Innenanschlag (33) umfasst, der ausgebildet ist, um eine minimale Höhe zwischen der Innenfläche der Rolle und der Fläche der elektrischen Karte sicherzustellen, wenn die Rolle auf der Fläche der elektrischen Karte befestigt ist.

7. Rolle nach Anspruch 1, umfassend erste Aufnahmemittel (30, 31), die geeignet sind, einen Steckverbinder vom Typ Wanddurchführungssteckverbinder aufzunehmen.

8. Rolle nach Anspruch 1, umfassend eine Positionierungsrippe (38), die ausgebildet ist, um in einen entsprechenden in der elektrischen Karte (50) ausgebildeten Positionierungsschlitz (56) eingefügt zu werden, um die Rolle korrekt zu positionieren.

9. System, umfassend eine elektrische Karte (50) und eine Rolle (10) nach einem der vorhergehenden Ansprüche.

10. System nach Anspruch 9, bei dem die ersten Befestigungsmittel Rastmittel umfassen, die dazu bestimmt sind, mit komplementären Rastmitteln der elektrischen Karte zusammenzuwirken, die in der Nähe eines Randes der elektrischen Karte angeordnet sind, wobei die komplementären Rastmittel der elektrischen Karte einen Raum umfassen, der zwischen einem lösbaren Abschnitt der elektrischen Karte und dem Rest der elektrischen Karte vorhanden ist.

11. System nach Anspruch 9, bei dem die elektrische Karte zweite Aufnahmemittel (57) umfasst, die geeignet sind, einen Steckverbinder vom Typ Wanddurchführungssteckverbinder aufzunehmen.

12. Montageverfahren zum Montieren einer elektrischen Ausrüstung, umfassend die Schritte:
- Befestigen einer Rolle (10) nach einem der Ansprüche 1 bis 7 an einem Rand der elektrischen Karte (50) mit Hilfe erster Befestigungsmittel der Rolle, wobei ein Kabel vom Typ Glasfaserkabel um die Rolle gewickelt ist;
- Umhüllen der Rolle mit einer Wärmeschutzvorrichtung;
- Löten der elektrischen Komponenten auf die elektrische Karte;
- Befestigen der Rolle auf der Fläche der elektrischen Karte mit Hilfe der zweiten Befestigungsmittel der Rolle;
- Integrieren der elektrischen Karte ins Innere eines Gehäuses der elektrischen Ausrüstung.

13. Montageverfahren nach Anspruch 12, bei dem das Löten der elektrischen Komponenten ein Schwalllöten ist.

14. Montageverfahren nach Anspruch 12, ferner umfassend die Schritte:
vor dem Löten der elektrischen Komponenten, Verbinden eines Steckverbinders vom Typ Wanddurchführungssteckverbinder mit einem Ende des Kabels und Positionieren des Steckers vom Typ Wanddurchführungssteckverbinder an ersten Aufnahmemitteln der Spule, die hierzu vorgesehen sind;
- nach dem Löten der Komponenten, Positionieren des Steckers an zweiten Aufnahmemitteln der elektrischen Karte, die hierzu vorgesehen sind.

## Claims

1. A reel for winding a cable segment (40) of optical fiber cable type, the reel comprising:
- a winding support (12) for supporting the cable segment;
- holder means adapted to hold the cable segment wound around the winding support;
- first fastener means arranged to fasten the reel to an edge of an electrical circuit card (50) so that the reel is positioned on one side of the circuit card;
- second fastener means arranged to fasten the reel flat against a face of the circuit card.

2. A reel according to claim 1, wherein the first fastener means comprise snap-fastener means (20) arranged to co-operate with complementary snap-fastener means of the circuit card arranged in the proximity of an edge of the circuit card.

3. A reel according to claim 1, wherein the holder means comprise at least one first tongue (13) that extends from one periphery of the reel (10) towards the winding support (12), and a second tongue (15) that extends from the winding support towards the periphery of the reel, the first tongue, the second tongue, the periphery of the reel (10), and the periphery of the winding support (12) together defining a channel (16) in which the cable segment extends.

4. A reel according to claim 3, wherein the first tongue (13) thus defines an axial inlet for the cable segment, while the second tongue (15) defines a radial inlet for the cable segment.

5. A reel according to claim 1, wherein the top face of the reel (10) has a top abutment (27) arranged to ensure some minimum distance between the top face of the reel (10) and a housing in which the circuit card is incorporated.

6. A reel according to claim 1, wherein a bottom face of the reel has a bottom abutment (33) arranged to ensure some minimum height between the bottom face of the reel and the face of the circuit card when the reel is fastened on the face of the circuit card.

7. A reel according to claim 1, including first docking means (30, 31) suitable for receiving a through connector of the type for passing through a partition.

8. A reel according to claim 1, including a positioning rib (38) arranged to be inserted in a corresponding positioning slot (56) formed in the circuit card (50) for positioning the reel correctly.

9. A system comprising an electric circuit card (50) and a reel (10) according to any preceding claim.

10. A system according to claim 9, wherein the first fastener means comprise snap-fastener means for cooperating with complementary snap-fastener means of the circuit card arranged in the proximity of an edge of the circuit card, the complementary snap-fastener means of the circuit card including a gap between a detachable portion of the circuit card and the remainder of the circuit card.

11. A system according to claim 9, wherein the circuit card includes second docking means (57) suitable for receiving a through connector of the type for passing through a partition.

12. An assembly method for assembling electrical equipment, the method comprising the following steps:
- fastening a reel (10) according to any one of claims 1 to 7 to an edge of the circuit card (50) by first fastener means of the reel, a cable of optical fiber cable type being wound around the reel;
- wrapping the reel in a thermal protection device;
- soldering electrical components to the circuit card;
- fastening the reel on the face of the circuit card by the second fastener means of the reel;
- incorporating the circuit card inside a housing of the electrical equipment.

13. An assembly method according to claim 12, wherein the electrical components are soldered by wave soldering.

14. An assembly method according to claim 12, further comprising the following steps:
- prior to soldering the electrical components, connecting to one end of the cable a through connector of the type for passing through a partition, and positioning the through connector on the first docking means of the reel provided for this purpose;
- after soldering the components, positioning the through connector on second docking means of the circuit card provided for this purpose.
